# EUROPEAN PATENT APPLICATION

(11) **EP 3 719 838 A1**
(43) Date of publication of application: **07.10.2020**
(21) Application number: 17933069.1
(22) Date of filing: 27.11.2017
(51) Int. Cl.: H01L 27/02, H02H 9/04, G09G 3/36

(54) **TFT SUBSTRATE, ESD PROTECTION CIRCUIT, AND METHOD FOR MANUFACTURING TFT SUBSTRATE**

(71) Applicant: Shenzhen Royole Technologies Co., Ltd., Shenzhen, Guangdong 518115 (CN)
(72) Inventor: KIM, Ji Ha, Shenzhen Guangdong 518115 (CN)
(74) Representative: Mewburn Ellis LLP
(86) International application number: PCT/CN2017/113151
(87) International publication number: WO 2019/100394

(57) **Abstract**

A TFT substrate, an ESD protection circuit, and a method for manufacturing the TFT substrate. The TFT substrate comprises: a base substrate (11); a first gate (12) provided on the base substrate (11); a first insulating layer (13) provided on the first gate (12); a drain(14), a source (15), and an active layer (16) provided on the first insulating layer (13); a second insulating layer (17) provided on the drain(14), the source (15), and the active layer (16); and a second gate (18) provided on the second insulating layer (17). In this way, display abnormality of a liquid crystal panel screen can be avoided.

## Description

### TECHNICAL FIELD

The invention relates to the field of liquid crystal display, in particular to a TFT substrate, an ESD protection circuit and a manufacturing method of TFT substrate.

### BACKGROUND TECHNIQUE

Since TFT-LCD (Thin Film Transistor Liquid Crystal Display) has the advantages of light, thin, low power consumption, etc., it is widely used in equipments such as televisions, notebook computers, mobile phones, etc..

As a flat panel display device, the liquid crystal panel of a liquid crystal display is usually composed of two glass substrates and a liquid crystal layer between the glass substrates. A number of data lines and a number of scanning lines are integrated on the lower glass substrate, and they are vertically staggered to form a number of unit areas, which are defined as pixel units. Each pixel unit mainly comprises devices such as pixel electrodes, storage capacitors and TFT transistors. The driving signal on the scanning line can control the working state of the TFT transistor, thereby writing the driving signal on the data line to the pixel electrode in a timely manner. The glass substrate forming the above-mentioned drive array is generally called a TFT substrate. A black matrix, a color filter film layer and a common electrode layer are integrated on the upper glass substrate. Since the upper glass substrate is provided with a color filter film layer, it is generally also called a color filter substrate. The TFT substrate and the color film substrate can be collectively referred to a liquid crystal display substrate.

However, in the manufacturing process of the liquid crystal display substrate, multiple processes such as development, etching, liquid crystal alignment into a cell, and transportation may cause electro-static discharge (ESD). The charge generated by static electricity will damage the TFT transistor device and the insulating layer, resulting in the degradation of the liquid crystal panel and affecting the production yield. Therefore, in the design of the liquid crystal panel, special paths and components for discharging static charges are also designed on the panel, such a design can be called an ESD protection circuit.

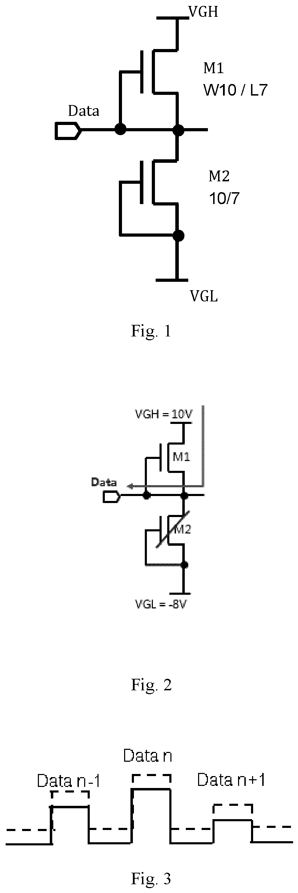

Fig. 1 is a schematic structural diagram of an ESD protection circuit in the prior art. In this ESD protection circuit, the source of the TFT transistor M1 is connected to the drain of the TFT transistor M2, and the drain of the TFT transistor M1 is connected to a positive voltage (VGH), and the source of the TFT transistor M2 is connected to a negative voltage (VGL), and the gate of the TFT transistor M1 is connected in parallel to its source, and the gate of the TFT transistor M2 is also connected in parallel to its source. The data signal (Data) is generated by the driver IC and output to the corresponding pixel electrode, the ESD protection circuit is passed in the middle of the process to prevent the problem of static electricity flowing in from the outside. When static electricity occurs, static electricity (a high voltage of -KV) flows in from the outside and is discharged to each VGH and VGL side. However, in this ESD protection circuit, due to the poor uniformity distribution of the initial turn-on voltage on the TFT transistor process, the initial turn-on voltage of the TFT transistor in actual products will move to a negative voltage, which means, the initial turn-on voltage of the TFT transistor is lower than 0. With reference to Fig. 2, the two TFTs M1 and M2 are turned on because the initial turn-on voltage is a negative voltage, thereby generating a large leakage current. When the data signal enters, due to the leakage current, the data signal (Data) is doped with a positive voltage (VGH), as shown in Fig. 3, where the solid line represents the data signal output from the driver IC, and the dotted line represents the data signal passed the ESD protection circuit. When the data signal is used to drive the pixel electrode, since the data signal is doped with an undesirable voltage, the brightness of the pixel electrode will be abnormal, thereby causing abnormality in the screen displayed by the liquid crystal panel.

### SUMMARY OF THE INVENTION

The technical problem to be solved by the present invention is that the above-mentioned TFT transistor of the prior art causes the abnormal display of liquid crystal panel when static electricity occurs due to the turn-on voltage is less than zero.

The technical solution adopted by the present invention to solve its technical problems is to construct a TFT substrate, comprising:
a base substrate;
a first gate provided on the base substrate;
a first insulating layer provided on the first gate;
a drain, a source and an active layer provided on the first insulating layer and at least a portion of the drain and at least a portion of the source are provided and spaced apart at the outer end of the active layer and connected through the active layer; and
a second insulating layer provided on the drain, the source, and the active layer;
a second gate provided on the second insulating layer, and the second gate is connected to a negative voltage.

Preferably, distances from the first gate and the second gate to the active layer are the same.

Preferably, the shape of the second gate is U-shaped.

Preferably, an orthographic projection of the active layer on the base substrate at least partially covers an orthographic projection of the first gate on the base substrate.

Preferably, the drain and the source are stepped and symmetrically provided at the outer end of the active layer.

Preferably, the first gate and the second gate have the same shape and size.

The present invention also constructs an ESD protection circuit, comprising the above-mentioned TFT substrate, and the TFT substrate comprises a first TFT transistor and a second TFT transistor, wherein a drain of the first TFT transistor is connected to a positive voltage signal, and a source of the second TFT transistor is connected to a negative voltage signal; a source of the first TFT transistor, a first gate of the first TFT transistor and a drain of the second TFT transistor M2 are connected to data signal altogether, and a first gate of the second TFT transistor is connected to the source.

Preferably, the second gate of the first TFT transistor and the second gate of the second TFT transistor are respectively connected to the source of the second TFT transistor.

The present invention also constructs a method for manufacturing a TFT substrate, comprising the following steps:
S11. providing a base substrate, and forming a first gate on the base substrate;
S12. forming a first insulating layer on the first gate and the substrate, and the first insulating layer completely covering the first gate;
S13. forming a drain, a source and an active layer on the first insulating layer, and at least a portion of the drain and at least a portion of the source being provided and spaced apart at the outer end of the active layer and connected through the active layer;
S14. forming a second insulating layer on the drain, the source and the active layer, and the second insulating layer completely covers the drain, the source and the active layer;
S15. forming second gate connected to a negative voltage on the second insulating layer.

Preferably, in the step S11, forming the first gate on the base substrate comprises:
depositing first metal layer on the base substrate, and patterning the first metal layer using a photolithography process to obtain the first gate;
or,
forming a first polysilicon layer on the base substrate, after performing N-type doping for the first polysilicon layer, patterning the N-type doped polysilicon layer by a photolithography process to obtain the first gate.

Preferably, the step S13 comprises:
depositing a semiconductor layer on the first insulating layer by a chemical or physical vapor deposition method, and patterning the semiconductor layer by a photolithography process to obtain the active layer;
depositing a second metal layer on the active layer and the first insulating layer, and patterning the second metal layer by a photolithography process to obtain the drain and the source; or, forming a polysilicon layer on the active layer and the first insulating layer, after performing N-type doping on the second polysilicon layer, patterning the N-type doped polysilicon layer by a photolithography process to obtain the drain and the source.

Preferably, the step S15 comprises:
depositing a third metal layer on the second insulating layer, and pattern the third metal layer by a photolithography process to obtain the second gate;
or,
forming a third polysilicon layer on the second insulating layer, performing N-type doping on the third polysilicon layer, and patterning the N-type doped polysilicon layer by a photolithography process to obtain the second gate.

Preferably, the photolithography process includes photoresist, exposure, development and etching processes.

In the implementation of the technical solution of the present invention, since the TFT substrate adopts a double gate structure, and the second gate is connected to a negative voltage, the turn-on voltage of the TFT transistor can be shifted to a positive direction. Moreover, when the TFT transistor is used to construct the ESD protection circuit, even if static electricity occurs, since the turn-on voltage of both TFT transistors is greater than 0, the leakage current is very small and can be ignored. In this way, the data signal output from the driver IC will not be doped with undesired voltage signal, so that the brightness of pixel electrode will not occur abnormal conditions, thereby avoiding the abnormality of the LCD screen.

### BRIEF DESCRIPTION OF THE DRAWINGS

In order to more clearly explain the embodiments of the present invention, the drawings used in the embodiments will be briefly introduced below. Obviously, the drawings in the following description are only some embodiments of the present invention. For those of ordinary skill in the art, other embodiments drawing may be obtained based on these drawings without any creative efforts. In the drawings:
Fig. 1 is a circuit structure diagram of an ESD protection circuit in the prior art;
Fig. 2 is a schematic diagram of the ESD protection circuit in Fig. 1 when static electricity occurs;
Fig. 3 is a waveform diagram of the input data signal and the output data signal when static electricity occurs;
Fig. 4 is a schematic structural view of embodiment 1 of the TFT substrate of the present invention;
Fig. 5 is a schematic diagram of the simulation of the turn-on voltage of the TFT transistor of the prior art and the TFT transistor of the present invention;
Fig. 6 is a circuit structure diagram of the ESD protection circuit of the present invention;
Fig. 7 is a flowchart of embodiment 1 of a method for manufacturing a TFT substrate of the present invention.

### DETAILED DESCRIPTION

In the following, the technical solutions in the embodiments of the present invention will be clearly and completely described with reference to the drawings in the embodiments of the present invention. Obviously, the described embodiments are only a part of the embodiments of the present invention, but not all of the embodiments. Based on the embodiments of the present invention, all other embodiments obtained by an ordinary person of skill in the art without creative efforts shall fall within the scope of protection of the present invention.

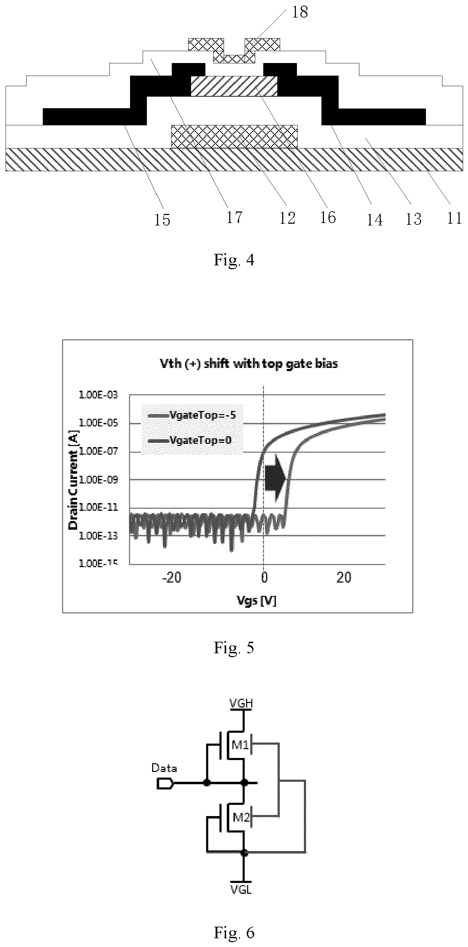

Fig. 4 is a schematic structural view of the embodiment 1 of the TFT substrate of the present invention. The TFT substrate of this embodiment comprises a stacked arrangement of a base substrate 11, a first gate 12, a first insulating layer 13, a drain 14, a source 15, an active layer 16, a second insulating layer 17, a the second gate 18. Wherein, the first gate 12 is provided on the base substrate 11 and has an area smaller than that of the base substrate 11, and is preferably provided in the middle portion of the base substrate 11. The first insulating layer 13 is provided on the first gate 12, the drain 14, the source 15 and the active layer 16 are provided on the first insulating layer 13, and at least a portion of the drain 14 and at least a portion of the source 15 are provided and spaced apart at the outer end of the active layer 16 and connected through the active layer 16. In addition, the second insulating layer 17 is provided on the drain 14, the source 15 and the active layer 16, covering the drain 14, the source 15 and the active layer 16, and the second gate 18 is provided on the second insulating layer 17, and the second gate 18 is connected to a negative voltage.

Moreover, in this embodiment, an orthographic projection of the active layer 16 on the base substrate 11 partially covers an orthographic projection of the first gate 12 on the base substrate 11. Of course, in other embodiments, the orthographic projection of the first gate 12 on the base substrate 11 may also be completely covered.

Further, the drain electrode 14 and the source electrode 15 are stepped, and are symmetrically provided at both ends and top of the active layer 16. Of course, in other embodiments, the drain 14 and the source 15 may have other shapes, and may also be provided at the left and right ends, the bottom, or the top of the active layer.

Further, the shape of the second gate 18 is U-shaped. Of course, in other embodiments, the shape, size of the first gate 12 and the second gate may be the same, and the distances from both of them to the active layer 16 are the same respectively. Of course, in other embodiments, the shape, size, and distances to the active layer 16 of both of them may are vary.

The TFT substrate of this embodiment adopts a double gate structure, and the first gate 12 and the second gate 18 are distributed on both sides of the active layer. When a voltage is applied to the first gate, an on-current of the conducting channel is generated, and because the second gate 18 is applied a negative voltage, the amount of current in the conducting channel is suppressed, thereby preventing the sectional area of the conductive channel from increasing, which is equivalent to increasing the turn-on voltage of the TFT transistor. With reference to Fig. 5, when the second gate 18 is not added, the turn-on voltage of the TFT transistor is -5V, and when the second gate 18 is added, the turn-on voltage of the TFT transistor shifts to the positive direction and becomes 0V.

Fig. 6 is a circuit structure diagram of the ESD protection circuit of the present invention. The ESD protection circuit of this embodiment comprises the TFT substrate shown in the above-mentioned embodiment, and the TFT substrate comprises a first TFT transistor M1 and a second TFT transistor M2, wherein the drain of the first TFT transistor M1 is connected to a positive voltage signal (VGH), the source of the second TFT transistor M2 is connected to a negative voltage signal (VGL), the source of the first TFT transistor M1, the first gate of the first TFT transistor M1 and the drain of the second TFT transistor M2 are connected to data signal (Data) altogether, and the first gate of the second TFT transistor M2 is connected to the source.

Preferably, the second gate of the first TFT transistor M1 and the second gate of the second TFT transistor M2 are respectively connected to the source of the second TFT transistor M2, so that without adding a voltage source, the existing negative voltage signal (VGL) is utilized to connect the second gate of the first TFT transistor M1 and the second gate of the second TFT transistor M2.

In this embodiment, after the driver IC outputs the data signal (Data), it is output to the pixel electrode through the ESD protection circuit, when static electricity occurs, since the turn-on voltages of the two TFTs M1 and M2 are greater than 0, the leakage current is very small and can be ignored, as thus the data signal (Data) will not be doped with undesired positive voltage signal (VGH), so that the data signal (Data) output to the pixel electrode is more accurate, and the brightness of pixel electrode will not occur abnormal conditions.

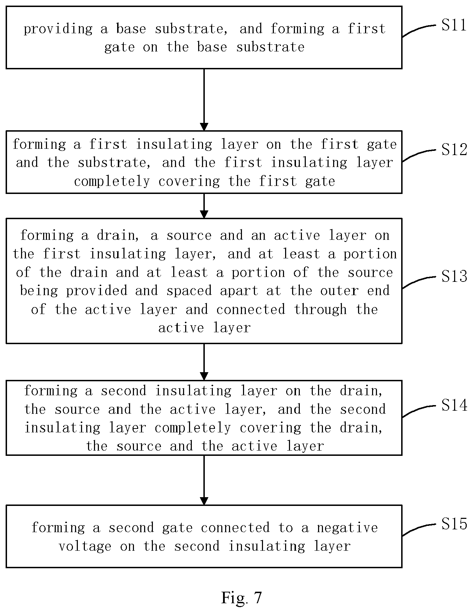

Fig. 7 is a flowchart of embodiment 1 of a method for manufacturing a TFT substrate of the present invention, and the method for manufacturing a TFT substrate in this embodiment comprises the following steps:
S11. providing a base substrate is provided, and forming a first gate on the base substrate;
   Specifically, in one example, the method for manufacturing the first gate may be: depositing a first metal layer on the base substrate, and patterning the first metal layer using a photolithography process to obtain the first gate. The material of the first metal layer may be aluminum, molybdenum, copper, or silver. Of course, in another example, the manufacturing method of the first gate may be: forming a first polysilicon layer on the base substrate, and performing N-type doping on the first polysilicon layer, and patterning the N-type doped polysilicon layer by a photolithography process to obtain the first gate.
S12. forming first insulating layer on the first gate and the substrate, and the first insulating layer completely covering the first gate;
S13. providing a drain, a source and an active layer on the first insulating layer and at least a portion of the drain and at least a portion of the source are provided and spaced apart at the outer end of the active layer and connected through the active layer;
   Specifically, the manufacturing method of the active layer may be: depositing a semiconductor layer on the first insulating layer by a chemical or physical vapor deposition method, and patterning the semiconductor layer by a photolithography process to obtain the active layer.
   Specifically, the manufacturing method of the drain and the source may be: depositing a second metal layer on the active layer and the first insulating layer, and patterning the second metal layer by a photolithography process to obtain the drain and the source; or forming a polysilicon layer on the active layer and the first insulating layer, performing N-type doping on the second polysilicon layer, and patterning the N-type doped polysilicon layer by a photolithography process to obtain the drain and the source.
S14. forming a second insulating layer on the drain, the source and the active layer, and the second insulating layer completely covering the drain, the source and the active layer;
S15. forming second gate connected to a negative voltage on the second insulating layer.

Specifically, the manufacturing method of the second gate may be: depositing a third metal layer on the second insulating layer, and patterning the third metal layer by a photolithography process to obtain the second gate; or forming a third polysilicon layer on the second insulating layer, and performing N-type doping on the third polysilicon layer, and patterning the N-type doped polysilicon layer by a photolithography process to obtain the second gate.

Further, the photolithography process in the above-mentioned embodiments includes photoresist, exposure, development and etching processes.

The above are only preferred embodiments of the present invention and are not intended to limit the present invention. For those skilled in the art, the present invention may have various modifications and changes. Any modification, equivalent replacement, improvement, etc. within the spirit and principle of the present invention shall be included in the scope of the claims of the present invention.

## Claims

1. A TFT substrate, comprising:
a base substrate;
a first gate provided on the base substrate;
a first insulating layer provided on the first gate;
a drain, a source and an active layer provided on the first insulating layer and at least a portion of the drain and at least a portion of the source being provided and spaced apart at the outer end of the active layer and connected through the active layer; and
a second insulating layer provided on the drain, the source, and the active layer;
a second gate provided on the second insulating layer, and the second gate is connected to a negative voltage.

2. The TFT substrate according to claim 1, wherein the distances from the first gate and the second gate to the active layer are the same.

3. The TFT substrate according to claim 1, wherein the second gate is U-shaped.

4. The TFT substrate according to claim 1, wherein an orthographic projection of the active layer on the base substrate at least partially covers an orthographic projection of the first gate on the base substrate.

5. The TFT substrate according to claim 1, wherein the drain and the source are stepped and symmetrically provided at the outer end of the active layer.

6. The TFT substrate according to claim 1, wherein the first gate and the second gate have the same shape and size.

7. An ESD protection circuit, comprising the TFT substrate according to any one of claims 1 to 6, and the TFT substrate comprises a first TFT transistor and a second TFT transistor, wherein a drain of the first TFT transistor is connected to a positive voltage signal, and a source of the second TFT transistor is connected to a negative voltage signal; a source of the first TFT transistor, a first gate of the first TFT transistor and a drain of the second TFT transistor are connected to data signal altogether, and a first gate of the second TFT transistor is connected to the source.

8. The ESD protection circuit according to claim 7, wherein the second gate of the first TFT transistor and the second gate of the second TFT transistor are respectively connected to the source of the second TFT transistor.

9. A method for manufacturing a TFT substrate, comprising the following steps:
S11. providing a base substrate, and forming a first gate on the base substrate;
S12. forming a first insulating layer on the first gate and the substrate, and the first insulating layer completely covering the first gate;
S13. forming a drain, a source and an active layer on the first insulating layer, and at least a portion of the drain and at least a portion of the source being provided and spaced apart at the outer end of the active layer and connected through the active layer;
S14. forming a second insulating layer on the drain, the source and the active layer, and the second insulating layer completely covering the drain, the source and the active layer; and
S15. forming a second gate connected to a negative voltage on the second insulating layer.

10. The method for manufacturing a TFT substrate according to claim 9, wherein in the step S11, forming the first gate on the base substrate, comprising:
depositing a first metal layer is deposited on the base substrate, and patterning the first metal layer by a photolithography process to obtain the first gate;
or,
forming a first polysilicon layer ion the base substrate, after performing N-type doping for the first polysilicon layer, patterning the N-type doped polysilicon layer by a photolithography process to obtain the first gate.

11. The method for manufacturing a TFT substrate according to claim 9, wherein the step S13 comprises:
depositing a semiconductor layer on the first insulating layer by a chemical or physical vapor deposition method, and patterning the semiconductor layer by a photolithography process to obtain the active layer;
depositing a second metal layer on the active layer and the first insulating layer, and patterning the second metal layer by a photolithography process to obtain the drain and the source; or, forming a second polysilicon layer on the active layer and the first insulating layer, after performing N-type doping for the second polysilicon layer, patterning the N-type doped polysilicon layer by a photolithography process to obtain the drain and the source.

12. The method for manufacturing a TFT substrate according to claim 9, wherein the step S15 comprises:
depositing a third metal layer on the second insulating layer, and patterning the third metal layer by a photolithography process to obtain the second gate;
or,
forming a third polysilicon layer on the second insulating layer, after performing N-type doping for the third polysilicon layer, patterning the N-type doped polysilicon layer by a photolithography process to obtain the second gate.

13. The method for manufacturing a TFT substrate according to any one of claims 10 to 12, wherein the photolithography process comprises photoresist, exposure, development and etching processes.
